Europäisches Patentamt

European Patent Office

Office européen des brevets

(11) Numéro de publication: **0 632 586 A1**

## DEMANDE DE BREVET EUROPEEN

(21) Numéro de dépôt: **94201780.7**

(22) Date de dépôt: **22.06.94**

(51) Int. Cl.6: **H03G 3/32**

(30) Priorité: **29.06.93 FR 9307923**

(43) Date de publication de la demande:
**04.01.95 Bulletin 95/01**

(84) Etats contractants désignés:
**DE FR GB**

(71) Demandeur: **LABORATOIRES D'ELECTRONIOUE PHILIPS**
**22, Avenue Descartes**
**F-94450 Limeil-Brévannes (FR)**

(84) **FR**

(71) Demandeur: **PHILIPS ELECTRONICS N.V.**

Groenewoudseweg 1
NL-5621 BA Eindhoven (NL)

(84) **DE GB**

(72) Inventeur: **Boyer, Jean-Philippe**
**Société Civile S.P.I.D.,**
**156, Boulevard Haussmann**
**F-75008 Paris (FR)**

(74) Mandataire: **Landousy, Christian et al**
**Société Civile S.P.I.D.**
**156, Boulevard Haussmann**
**F-75008 Paris (FR)**

(54) **Dispositif de commande automatique de sons à logique floue.**

(57) Dispositif (10) de commande automatique de sons comprenant des moyens de détection (14) pour délivrer des mesures objectives de sons et/ou de bruits concernant un volume sonore ambiant, et des moyens de commande (18) à logique floue pour régler, d'après les mesures de bruit ambiant, des caractéristiques d'émission sonore délivrée par un équipement acoustique (5). Le dispositif comprend, entre les moyens de détection (14) et les moyens de commande (18), des moyens de conversion (16) à logique floue qui transforment les mesures objectives de bruit ambiant en mesures subjectives de bruit ambiant pour opérer lesdits réglages.

Le dispositif peut apprendre des réglages personnalisés à un auditeur. Il peut également détecter de la parole et opérer des réglages spécifiques.

Application : autoradio, appareils de reproduction sonore, téléviseur.

FIG.1

L'invention concerne un dispositif de commande automatique de sons comprenant des moyens de détection pour délivrer des mesures objectives de sons et/ou de bruits concernant un volume sonore ambiant, et des moyens de commande à logique floue pour régler, d'après les mesures de bruit ambiant, des caractéristiques d'émission sonore délivrée par un équipement acoustique.

Elle concerne plus particulièrement des équipements acoustiques tels que autoradio, appareil de reproduction sonore, téléviseur, magnétoscope ou autres.

De tels équipements acoustiques peuvent nécessiter au cours de leur utilisation d'avoir leur puissance sonore réglée à l'aide de commandes automatiques pour tenir compte de l'environnement et des conditions d'exploitation dans lesquels ils sont utilisés. En effet, ces environnements sont par eux-mêmes générateurs de sons et/ou de bruits dont il faut tenir compte, parfois très rapidement, pour adapter la puissance sonore qu'ils délivrent.

Une situation particulièrement significative se présente avec l'utilisation d'un autoradio ou plus généralement d'un équipement acoustique dans un véhicule automobile. D'une part, l'autoradio est muni de fonctions de plus en plus nombreuses et le conducteur doit disperser son attention pour sélectionner le bouton adéquat pour effectuer un réglage requis. Le temps qu'il doit y consacrer s'avère de plus en plus long ce qui devient préjudiciable à une conduite du véhicule en toute sécurité. D'autre part, un véhicule constitue une source de bruits divers qu'il n'est pas possible d'éliminer complètement et l'intensité de ces bruits divers évolue souvent rapidement avec l'évolution du trafic, donc avec la vitesse du véhicule, ce qui perturbe ainsi de façon variable l'audition.

Il peut aussi être nécessaire de réduire la puissance sonore délivrée par l'équipement acoustique lors d'un appel téléphonique, d'une conversation ou d'autres causes de génération de bruits ambiants.

Un conducteur ne peut donc pas nécessairement au bon moment distraire son attention pour régler l'autoradio. Un système de commande automatique prend donc là toute son importance en libérant l'auditeur d'avoir à effectuer lui-même cette tâche.

Pour des équipements acoustiques situés dans un lieu d'écoute fixe des problèmes similaires apparaissent également.

Pour tenir compte du volume sonore ambiant et asservir la puissance sonore de l'équipement acoustique, on a pensé à des solutions faisant intervenir la logique floue. Ainsi, on connaît le document JP-A - 4 207611 qui décrit un système de commande pour un équipement acoustique (autoradio) disposé dans un véhicule. Ce dispositif comprend un contrôleur à logique floue qui reçoit d'une part, à travers un microphone, une mesure de la totalité des sons et bruits ambiants et d'autre part une indication de la vitesse du véhicule pour tenir compte des variations du bruit dû à la vitesse.

Le contrôleur à logique floue met en oeuvre des ensembles flous et des règles d'inférence pour déduire des actions à entreprendre en fonction des valeurs de sons et de bruits ambiants et de la vitesse. Ces actions consistent à agir sur un organe de commande qui règle la puissance sonore de l'autoradio d'après les règles d'inférence préétablies.

Or, les problèmes qui se posent dans la réalisation d'un système de commande automatique efficace résident dans le fait que le détecteur à prendre en considération est en fait l'oreille humaine. Celle-ci ne se comporte pas comme un simple microphone car la réaction de l'auditeur est très dépendante de la sensation de bruit qu'il ressent. Il est de plus très difficile de modéliser cette sensation de bruit qui s'avère être très subjective.

Le but de l'invention est ainsi de concevoir un système qui prenne en compte les notions imprécises de perception de bruit par l'auditeur.

Ce but est atteint avec un dispositif de commande automatique qui comprend, entre les moyens de détection et les moyens de commande, des moyens de conversion à logique floue qui transforment les mesures objectives de bruit ambiant en mesures subjectives de bruit ambiant, lesdits moyens de conversion délivrant un signal de mesure subjective de bruit qui pilote les moyens de commande pour opérer lesdits réglages.

Ainsi les paramètres subjectifs peuvent intervenir avantageusement dans le fonctionnement du dispositif de commande.

Les mesures objectives concernent aussi bien des mesures quantitatives, c'est-à-dire le niveau sonore, que des mesures qualitatives c'est-à-dire le contenu basse fréquence, moyenne fréquence, haute fréquence des sons. Les transformations des mesures objectives en mesures subjectives sont effectuées dans les moyens à logique floue en définissant des ensembles flous et des règles d'inférence. Pour cela les moyens de conversion et les moyens de commande sélectionnent de manière déterministe des réglages de l'équipement acoustique en mettant en oeuvre des ensembles flous respectifs préétablis et des règles d'inférence préétablies. Ainsi les mesures subjectives traduisent ce que ressent un auditeur moyen placé dans l'environnement où est placé l'équipement acoustique.

EP 0 632 586 A1

Il est également possible de personnaliser le dispositif de commande en permettant à l'utilisateur d'introduire des réglages personnalisés. Pour cela l'équipement acoustique dispose de boutons de commande pour faire varier le gain en sortie ou la balance graves-aigus, ce qui permet à l'auditeur d'effectuer des réglages personnalisés. Les moyens de conversion et les moyens de commande scrutent ces réglages personnalisés et s'auto-adaptent conformément auxdits réglages. Cette auto-adaptation peut être faite au coup par coup à chaque réglage personnalisé formulé. Plus particulièrement encore les moyens de conversion et les moyens de commande peuvent tenir compte du cumul des réglages personnalisés de l'auditeur. Ainsi le dispositif de commande apprend peu à peu les désirs personnalisés de l'auditeur dans l'environnement d'utilisation de l'équipement acoustique.

Le dispositif de commande peut de plus discerner un son de parole d'un son musical et intervenir sur les réglages de l'équipement acoustique. Le son de parole peut soit être détecté directement dans l'habitacle ou dans la pièce où est situé l'équipement soit être détecté dans le signal activant l'organe de diffusion de l'équipement acoustique. Les réglages sont différents dans les deux cas.

Il peut s'agir d'un autoradio placé dans un véhicule automobile, d'un téléviseur, d'un lecteur de compact disque, d'un magnétophone, d'un magnétoscope ou autres placés dans un lieu d'écoute.

Ces différents aspects de l'invention et d'autres encore seront apparents et élucidés à partir des modes de réalisation décrits ci-après.

L'invention sera mieux comprise à l'aide des figures suivantes données à titre d'exemples non limitatifs qui représentent :

Figure 1 : un dispositif de commande automatique selon l'invention, connecté à un équipement acoustique.

Figure 2 : un schéma des moyens de mesure objective du bruit ambiant et des moyens de conversion à logique floue pour en déduire une mesure subjective de bruit.

Figure 3 : un schéma d'une partie du dispositif avec un moyen d'extraction de mesure objective non sélective de bruit.

Figure 4 : une première représentation (A) d'ensembles flous mis en oeuvre par les moyens de conversion et une seconde représentation (B) d'ensembles flous mis en oeuvre par les moyens de commande pour mesurer un degré d'appartenance.

Figure 5 : un schéma de principe d'un contrôleur à logique floue.

Figure 6 : un diagramme d'une surface de mesures subjectives de bruit.

Figure 7 : un schéma d'un étage de détection sélective d'une énergie sonore.

Figure 8 : une courbe de variation de gain en fonction de la mesure subjective de bruit.

Figure 9 : un schéma d'une partie du dispositif avec un module de filtrage d'un son de parole.

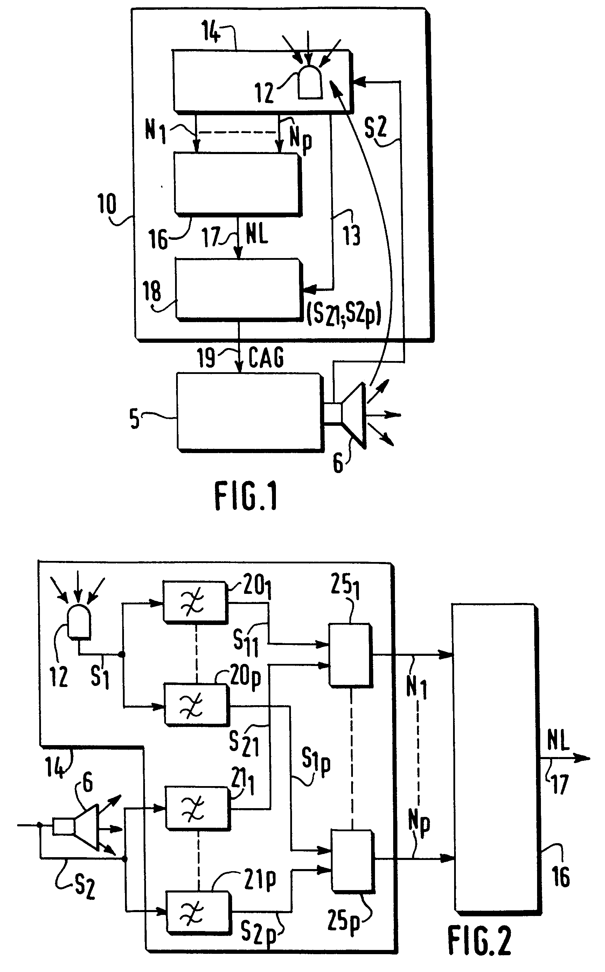

La figure 1 représente un dispositif de commande automatique 10 selon l'invention relié à un équipement acoustique 5. Celui-ci est muni d'un organe 6 d'émission sonore et d'un amplificateur de sortie à gain variable (non representé). Le dispositif 10 comprend :

- des moyens de détection 14 pour mesurer un niveau sonore et délivrer des mesures objectives de bruit, sous la forme de plusieurs composantes $N_1 ... N_p$ de l'énergie du bruit dans différentes bandes de fréquences,
- des moyens de commande 18 à logique floue pour délivrer un signal CAG 19 de commande automatique du son de l'équipement acoustique 5,
- et, entre les moyens de détection 14 et les moyens de commande 18, sont disposés des moyens de conversion 16 à logique floue pour délivrer une mesure subjective de bruit à partir des mesures objectives de bruit. Les moyens de conversion 16 transforment les composantes $N_1 .... N_p$ de bruit en un signal de perception NL 17 mesurant une sensation de bruit perçue par un auditeur.

Selon l'invention, on tient compte du fait que la perception du bruit par l'oreille humaine n'est pas identique à une mesure objective du bruit effectuée par un instrument de mesure. Néanmoins, cette mesure objective du bruit est à réaliser préalablement afin de la transformer en mesure subjective. Cette mesure objective des caractéristiques sonores est réalisée dans les moyens de détection 14 dont un schéma détaillé est représenté sur la figure 2. Les moyens de détection 14 comprennent un capteur 12 qui capte les sons ambiants incluant, selon leurs niveaux, les sons issus de l'organe 6 d'émission sonore. Le capteur peut être un microphone ou tout détecteur dont le signal de sortie est corrélé au bruit par exemple un détecteur de vitesse dans le cas d'une automobile, un détecteur de vibrations ou autres.

Sur une première voie, le signal S1, délivré par le microphone, entre dans une batterie d'étages $20_1$ - $20_p$ de mesures sélectives d'énergie sonore, chaque étage filtrant l'énergie du signal dans respectivement une partie déterminée du spectre de fréquences.

De la même manière sur une seconde voie, le signal S2, qui active un haut-parleur 6 (organe d'émission sonore), est filtré par des étages $21_1$ - $21_p$ appariés deux à deux aux étages précédents. Ainsi à

EP 0 632 586 A1

la sortie de l'étage $20_1$ et de l'étage $21_1$ par exemple, on dispose de deux signaux filtrés mesurant une énergie sur des gammes appariées de fréquences, avec dans un cas des mesures en provenance de l'ambiance sonore et dans l'autre cas des mesures en provenance directement de la sortie de l'équipement sonore. De même pour les autres étages appariés. Cet appariement peut éventuellement tenir compte des particularités fréquencielles différentes dues aux trajets différents d'où émanent S1 et S2. Par exemple dans le cas de l'utilisation d'un microphone, l'appariement tient compte des caractéristiques respectives des haut-parleurs et du microphone. De même, il peut être utile de prendre en compte les signaux sur la totalité du spectre acoustique ce qui revient à placer un filtre à bande très large voire à prendre la totalité des signaux pour un étage et son étage apparié.

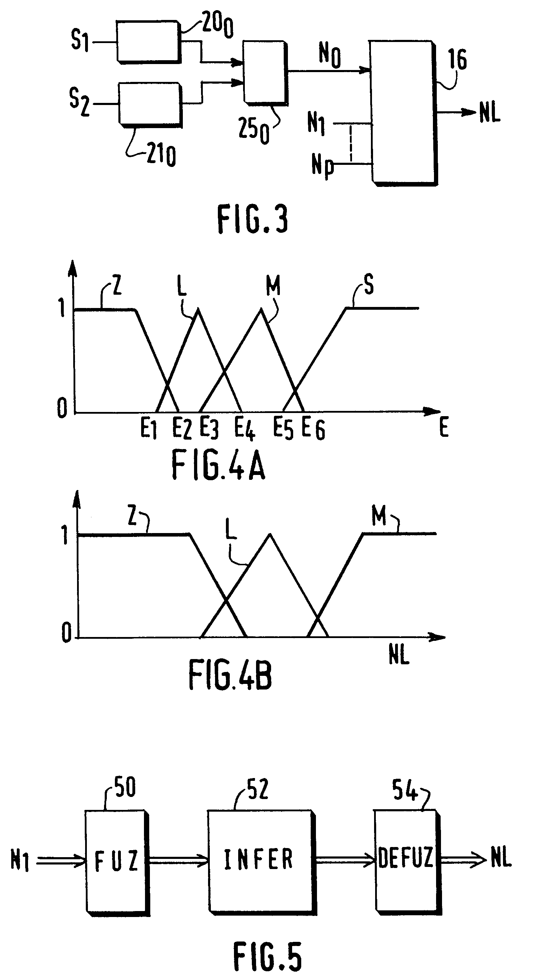

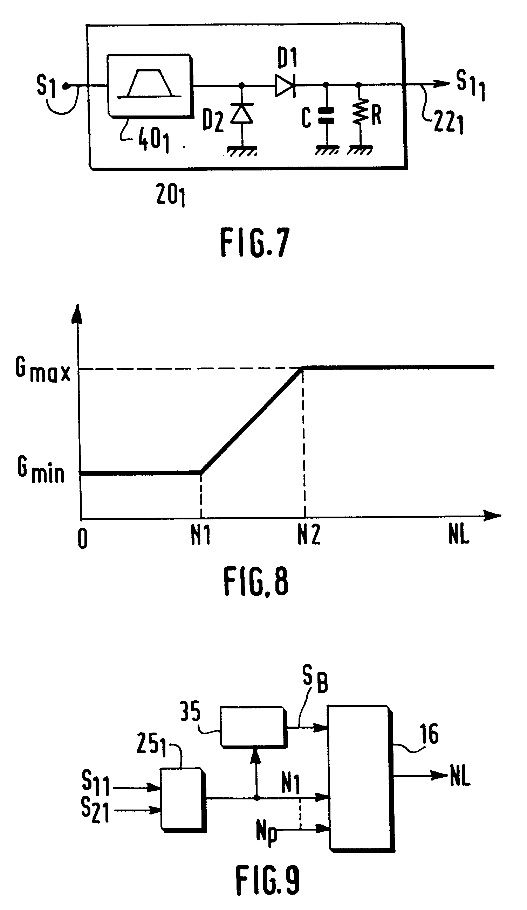

Le signal S2 prélevé en sortie du haut-parleur ne renferme que le signal sonore utile. Le signal S1 en sortie du microphone renferme le signal sonore utile transmis par voie acoustique au microphone, ainsi que les bruits et les autres sons ambiants. Il est donc possible d' éliminer le signal S2 du signal S1 pour obtenir une mesure objective des bruits et sons ambiants. Ceci est effectué sur les composantes filtrées (S11 - S1p) (S21 - S2p) issues des étages appariés des deux voies, par soustraction ou filtrage adaptatif, dans des modules d'extraction $25_1$,... $25_p$. Le filtrage adaptatif peut mettre en oeuvre la technique connue de suppression d'échos. On obtient ainsi des composantes de bruit $N_1 - N_p$ se rapportant aux gammes de fréquences sélectionnées. Ces composantes de bruit entrent dans les moyens de conversion 16 à logique floue qui délivrent le signal de perception NL donnant une mesure subjective de bruit. Plus particulièrement, il peut exister des modules de détection $20_0$, $21_0$ et un module d'extraction $25_0$ (figure 3) qui éliminent la totalité du signal S2 inclus dans le signal S1. Les modules de détection $20_0$, $21_0$ sont analogues aux modules $20_1$, $21_1$ sauf que les filtres 40 ou bien sont à large bande audio ou bien n'existent pas (figure 7). On obtient alors une composante de bruit $N_0$ qui n'est pas sélective en fréquence. Cette composante $N_0$ participe avec les autres composantes $N_1 - N_p$ à la détermination du signal de perception NL.

Un exemple de réalisation d'un étage de mesure sélective d'énergie sonore, par exemple l'étage $20_1$, est représenté sur la figure 7. L'étage $20_1$ comprend un filtre $40_1$ passe-bas ou passe-haut ou passe-bande selon la gamme de fréquences choisie et un circuit de détection et de filtrage pour mesurer l'énergie du signal dans la gamme de fréquences délimitée par le filtre $40_1$. Le circuit de détection et de filtrage comprend une diode D1 connectée en direct entre la sortie du filtre $40_1$ et une sortie $22_1$ du circuit, une diode D2 connectée en inverse entre la sortie du filtre et un potentiel de référence (la masse), une cellule d'intégration formée d'une capacité C en parallèle avec une résistance R connectée entre la sortie $22_1$ et le potentiel de référence (masse). Le signal S11 sur la sortie $22_1$ représente une mesure de l'énergie du signal d'entrée S1 dans la gamme de fréquences délimitée par le filtre $40_1$. Tout autre montage remplissant la même fonction convient.

Les moyens de conversion 16 et les moyens de commande 18 opèrent selon les principes connus de la logique floue. Les figures 4 et 5 fournissent un simple rappel des principes essentiels.

La figure 4-A constitue un exemple d'ensembles flous se rapportant à une variable, par exemple le signal $N_1$, mesurant l'énergie du bruit filtré sélectivement. On définit les ensembles flous suivants :

| | |
|---|---|
| - ensemble Z de bruit nul lorsque | $E < E_2$ |
| - ensemble L de bruit faible lorsque | $E_1 < E < E_4$ |
| - ensemble M de bruit moyen lorsque | $E_3 < E < E_6$ |
| - ensemble S de bruit fort lorsque | $E > E_5$ |

Toutes les composantes $N_0 - N_p$ sont ainsi traduites de la même manière en ensembles flous qui sont stockés dans les moyens de conversion 16. Dans le mode utilisation, une donnée courante d'entrée pourra ainsi appartenir à un ou plusieurs ensembles flous. Des règles d'inférence sont ensuite appliquées pour en déduire une mesure de la sensation subjective de bruit. Ces règles sont du type "SI $N_1$ est fort ET $N_0$ est moyen ALORS NL est fort". Pour chaque règle d'inférence, on obtient une déduction et de toutes les déductions on extrait un signal NL de mesure de sensation de bruit. Cette dernière opération appelée défuzzyfication peut être supprimée pour éviter d'effectuer l'opération inverse à l'entrée des moyens de commande 18. Le signal NL reste alors représenté sous la forme d'ensembles flous. Les moyens de commande 18 opèrent également à l'aide d'ensembles flous et de règles d'inférence. La figure 4-B représente, pour les moyens de commande 18, des exemples d'ensembles flous avec en abscisse le niveau NL subjectif de bruit et en ordonnée le degré d'appartenance à l'ensemble flou. Ce diagramme se décompose également par exemple en ensembles flous nul (Z), faible (L) et moyen (M). Une même valeur NL peut ainsi appartenir à un ou plusieurs ensembles flous selon plusieurs degrés d'appartenance. Les moyens de commande 18 reçoivent la mesure subjective NL et au moins une composante filtrée

4

sélectivement du signal 52 (connexion 13 - figure 1). Ces composantes filtrées sont prises parmi les composantes filtrées S21 à S2p fournies par les moyens de détection 14 (figure 2). Puis des règles d'inférence sont appliquées. Enfin une opération de défuzzyfication est effectuée pour en déduire l'action à entreprendre c'est-à-dire délivrer le signal de commande automatique de gain. Ces opérations de logique floue sont schématisées sur la figure 5 où on a représenté un module 50 FUZ qui effectue une fuzzification de N1, un module INFER 52 qui applique des règles d'inférence et un module DEFUZ 54 qui effectue une defuzzification des données.

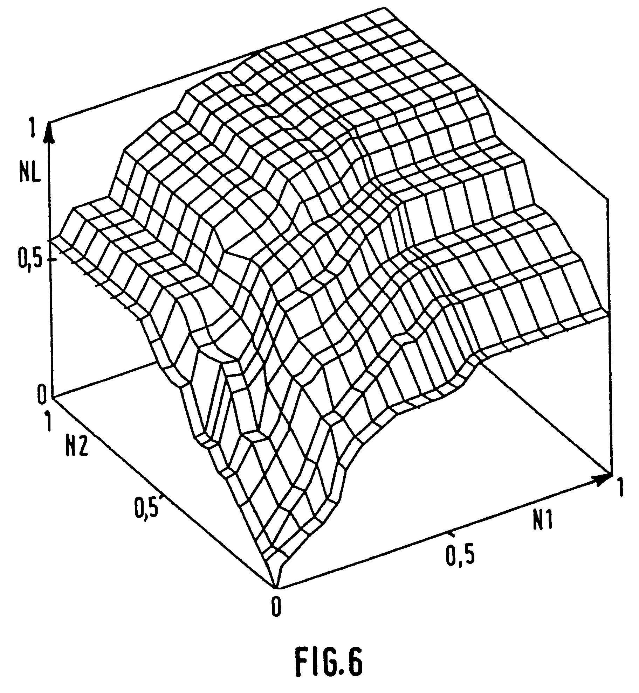

La mesure subjective NL de bruit dépend des différentes composantes $N_0$ - $N_p$ de bruit. Pour permettre une représentation simple, considérons le cas particulier de deux composantes $N_1$ et $N_2$ pour lesquelles les gammes de fréquences correspondaient respectivement aux "BASS" et aux "MEDIUM". Dans le cas particulier d'une mesure subjective de bruit pour un autoradio placé dans une automobile, on a obtenu une dépendance NL = f ($N_1$, $N_2$) représentée par la surface de la figure 6. Cette surface dont l'expression analytique serait très complexe peut être aisément déterminée à l'aide de la logique floue. La complexité de cette surface croit lorsque le nombre d'entrées croît de deux composantes de bruit à p composantes de bruit.

Les moyens de commande 18 déterminent le signal de commande CAG qui est appliqué sur l'amplificateur de l'équipement acoustique (figure 1) pour modifier le signal S2 appliqué au haut-parleur 6. A titre d'exemple, une allure des variations de la dynamique du gain de l'amplificateur en fonction du niveau de bruit NL est représentée sur la figure 8. Lorsque le niveau de bruit NL est inférieur à N1, le gain de l'amplificateur de sortie est réglé à une valeur minimale Gmin. Entre $N_1$ et $N_2$, le gain de l'amplificateur peut varier par exemple, sensiblement linéairement avec le niveau de bruit NL. Au-dessus de N2 le gain est gardé constant à une valeur maximale Gmax.

A l'initialisation, la courbe de gain est positionnée automatiquement sur un point de mesure instantanée du signal S2 obtenu dans un bruit N mesuré par le système en début lors de la mise en route du dispositif. Ceci consiste à mesurer le niveau du signal S2 imposé par l'utilisateur lors de la mise en route de l'appareil ainsi que le niveau du bruit ambiant détecté au même instant. A partir du couple mesuré (S2, N) et de la courbe de la figure 8, on en déduit une courbe de consigne pour le signal S2 en fonction du bruit. En fonctionnement automatique lorsqu'une mesure instantanée du signal S2 n'est pas sur la courbe de consigne cela entraîne une correction automatique de gain.

Selon l'invention, l'utilisation du dispositif de commande automatique peut être limitée à la sélection déterministe des réglages. Dans ce cas, les ensembles flous et les règles d'inférence (figure 4) sont préétablis. Pour les déterminer, on place l'équipement acoustique dans un environnement déterminé et à partir de sensations de bruit perçues par un ou plusieurs auditeurs, on détermine les bornes des ensembles flous et les règles d'inférence concernant les moyens de conversion. Par la suite, en fonctionnement, le dispositif de commande automatique mesure un niveau subjectif NL de bruit et adapte automatiquement la puissance sonore de l'équipement acoustique d'après lesdits ensembles flous et lesdites règles.

Selon un mode particulier, il est possible de personnaliser le dispositif de commande automatique en fonction de réglages établis par l'auditeur. Dans ce mode, le dispositif, à sa première mise en fonctionnement, opère par exemple selon les réglages déterministes ci-dessus. Néanmoins, dans certaines conditions, ces réglages déterministes peuvent ne pas convenir à l'auditeur. La puissance sonore émise par exemple peut être soit trop élevée soit trop faible. L'auditeur peut alors manoeuvrer des boutons de commande placés sur l'autoradio pour régler les sons à sa convenance (volume, basses, aigus). Les moyens à logique floue interprètent alors cette intervention comme une requête de modifications et modifient en conséquence les bornes du ou des ensembles flous qui opéraient préalablement. Cette modification peut être temporaire, par exemple pour la durée d'utilisation de l'autoradio au cours de laquelle sont effectués les réglages, ou au contraire peut être stockée dans le dispositif jusqu'à ce qu'un nouveau réglage se présente. Les réglages deviennent ainsi personnalisés à l'auditeur.

Dans un mode encore plus évolué, les réglages établis successivement par l'auditeur sont progressivement cumulés de sorte que peu à peu le dispositif apprend à s'adapter d'après les réglages successifs de l'auditeur. On obtient ainsi un dispositif de commande automatique personnalisé. Cette personnalisation peut être obtenue en modifiant les bornes des ensembles flous comme cela vient d'être indiqué ou en pondérant les règles d'inférence ou en associant ces deux modes d'intervention. Cette pondération peut être obtenue par application de méthodes neuronales. Dans ce cas, les moyens de conversion et les moyens de commande à logique floue disposent de moyens neuronaux pour pondérer les règles d'inférence. Par exemple si une règle d'inférence est validée avec un degré d'appartenance de 0,5, ce degré peut être à son tour révisé par un coefficient de pondération appliqué par les moyens neuronaux.

Pour accroître les performances du dispositif et tenir compte de réglages déjà effectués, les moyens de commande 18 peuvent appliquer des règles d'inférence supplémentaires qui tiennent compte du réglage automatique déjà effectué. Comme cela a été décrit précédemment, lorsqu'une mesure instantanée de signal S2 n'est pas en accord avec la courbe de consigne déterminée ceci donne lieu à une commande automatique de gain. Il est néanmoins possible de moduler ces règles dans certaines situations.

En effet, une modification de la puissance sonore pourra ne pas être proportionnellement la même selon que les corrections précédentes ont porté le niveau de puissance sonore à un niveau fort, moyen ou faible. Une règle d'inférence peut imposer que lorsque le dernier réglage a modifié la puissance sonore d'une quantité déterminée, le réglage suivant ne peut alors être modifié que d'une autre quantité déterminée. Des réglages successifs peuvent ainsi être dans la dépendance des réglages qui les précèdent. Les règles d'inférence spécifiques peuvent ainsi tenir compte de niveaux successifs du signal S2.

Il est possible d'établir des règles d'inférence qui tiennent compte de la morphologie de l'énoncé sonore délivré par l'équipement acoustique. En particulier une pièce musicale peut être formée de séquences "MODERATO" "FORTE" "PIANISSIMO" et ainsi de suite. Il est en particulier souhaitable que le dispositif de commande automatique ne modifie pas la puissance sonore pour délivrer une séquence "PIANISSIMO" qui ne soit pas en harmonie avec une séquence "FORTE" par exemple.

A la mise en route, lors de la phase initiale de scrutation des réglages par le dispositif, pour détecter les blancs ou les fins de morceaux, le dispositif mesure la valeur du niveau moyen Sref du signal S2 imposé par l'auditeur. Le dispositif recalcule alors le niveau moyen dans une ambiance à bruit déterminé. La valeur de Sref (à bruit déterminé) ainsi réglée est supposée être la valeur correcte qui satisfait l'auditeur. Cette valeur Sref est associée à une valeur constante Gc du gain.

D'autre part, par construction, on connaît à tout instant la valeur G du gain appliqué par le dispositif. Il est donc possible à tout moment, à partir de la valeur moyenne du signal S2, de calculer le rapport

$$So = \frac{Gc.S2}{G}.$$

Ce rapport est alors comparé à la valeur Sref du signal S2 qui correspond à un gain Gc constant.

Ultérieurement, en cours d'utilisation, il suffit de mesurer la valeur moyenne courante du signal S2 et de déterminer la valeur So pour la valeur correspondante du gain G.

Le rapport So/Sref est converti en ensembles flous du type de ceux de la figure 4-A, par exemple, tel que :

TABLEAU 1

Lorsque le rapport So/Sref est dans l'ensemble flou "très faible" (Tableau 1) ceci signifie qu'il s'agit d'un passage "PIANISSIMO" et qu'il ne faut pas modifier le gain.

De même, il est souhaitable de détecter la fin d'une émission sonore pour ne pas commander intempestivement un accroissement de puissance sonore ce qui se traduirait par une puissance sonore trop élevée lors de la reprise subséquente du signal. Cette détection est faite comme précédemment et correspond à l'appartenance exclusive de So/Sref à l'ensemble flou "très faible".

6

Il est possible de faire que le dispositif de commande automatique identifie des périodes de paroles dans la mesure subjective de bruit NL. Pour cela on met à profit le fait connu que la parole est constituée de sons groupés par paquets. On peut ainsi détecter des bouffées de paroles. Pour cela les moyens à logique floue comparent la composante N(t) mesurée à une réplique retardée $N(t - \Delta t)$. La composante N(t) est choisie parmi celles qui correspondent, par exemple, à des gammes 200 Hz - 3 KHz, dans lesquelles on est susceptible de trouver la parole. Cette comparaison peut être obtenue par exemple par filtrage. Elle fournit un taux de composantes à haute fréquence supérieur pour un signal de parole au taux correspondant à un signal de bruit.

A partir des composantes à haute fréquence issues de cette comparaison, on extrait un signal $S_B$ de bouffées de parole. La figure 9 représente un module de filtrage 35 qui détermine les composantes hautes fréquences précédentes et détermine le signal $S_B$.

Les moyens de conversion 16 peuvent ainsi traiter en logique floue le signal $S_B$ à l'aide d'ensembles flous et de règles d'inférence spécifiques. Les moyens de conversion 16 reçoivent alors en entrée $N_1 ... N_p$, $S_B$. Le signal $S_B$ est pris en compte en ajoutant des règles d'inférence lorsque la parole est détectée.

Ainsi, lorsqu'un signal de parole est détecté, le dispositif de commande automatique peut abaisser le volume sonore délivré par l'équipement acoustique et inversement, lorsqu'un signal de parole n'est pas détecté, il peut l'asservir au bruit ambiant comme cela a été décrit.

Il est également possible que le dispositif de commande automatique identifie des périodes de paroles dans le signal S2 délivré au haut-parleur. La détection de la parole peut être effectuée selon les techniques connues par exemple décrites dans le document US - 4.959.865. Lorsque des périodes de paroles sont détectées dans le signal S2, le dispositif selon l'invention agit sur l'équilibrage graves/aigus de l'égaliseur en fonction du bruit ambiant de façon à améliorer l'intelligibilité des paroles émises. Lorsque des périodes de paroles ne sont pas détectées, le signal S2 est alors supposé être musical et des réglages appropriés sont appliqués sur l'égaliseur pour adapter la balance graves/aigus.

**Revendications**

1. Dispositif (10) de commande automatique de sons comprenant des moyens de détection (14) pour délivrer des mesures objectives de sons et/ou de bruits concernant un volume sonore ambiant, et des moyens de commande (18) à logique floue pour régler, d'après les mesures de bruit ambiant, des caractéristiques d'émission sonore délivrée par un équipement acoustique (5), caractérisé en ce que le dispositif comprend, entre les moyens de détection (14) et les moyens de commande (18), des moyens de conversion (16) à logique floue qui transforment les mesures objectives de bruit ambiant en mesures subjectives de bruit ambiant, lesdits moyens de conversion (16) délivrant un signal (NL) de mesure subjective de bruit qui pilote les moyens de commande (18) pour opérer lesdits réglages.

2. Dispositif selon la revendication 1 caractérisé en ce que les moyens de détection (14) comprennent un capteur (12) qui fournit le niveau sonore ambiant, une première batterie d'étages de détection ($20_1$ - $20_p$) et une seconde batterie d'étages de détection ($21_1$ - $21_p$) pour fournir des mesures sélectives d'énergie sonore en filtrant respectivement un signal (S1) de sortie du capteur et un signal (S2) de sortie de l'équipement acoustique (5) et pour délivrer respectivement au moins un premier signal sélectif (S11 - S1p) et au moins un second signal sélectif (S21 - S2p), les étages de détection des batteries étant appariés deux à deux, et des moyens d'extraction ($25_1$ - $25_p$) pour éliminer, pour chaque couple d'étages appariés, le second signal sélectif du premier signal sélectif, les moyens d'extraction délivrant une pluralité de mesures objectives sélectives ($N_1$ -$N_p$) de bruit aux moyens de conversion (16) pour qu'ils délivrent ledit signal (NL) de mesure subjective.

3. Dispositif selon la revendication 2 caractérisé en ce qu'il comprend des moyens de détection supplémentaires ($20_0$, $21_0$, $25_0$) qui délivrent une mesure ($N_0$) objective et non sélective de bruit en éliminant directement le signal de sortie (S2) audio de l'équipement acoustique du signal de sortie (S1) audio du capteur, les moyens de conversion (16) recevant en entrée les mesures ($N_1$ - $N_p$) objectives sélectives et la mesure ($N_0$) objective non sélective.

4. Dispositif selon une des revendications 1 à 3 caractérisé en ce que les moyens de conversion et les moyens de commande sélectionnent de manière déterministe des réglages de l'équipement acoustique en mettant en oeuvre des ensembles flous respectifs préétablis et des règles d'inférence préétablies.

**5.** Dispositif selon une des revendications 1 à 3 caractérisé en ce que les moyens de conversion et les moyens de commande sont aptes à adapter leurs ensembles flous respectifs et/ou leurs règles d'inférence respectives pour apprendre des réglages personnalisés formulés' par l'auditeur.

**6.** Dispositif selon la revendication 5 caractérisé en ce que les moyens de conversion et les moyens de commande sélectionnent lesdits réglages personnalisés en apprennant cumulativement les réglages personnalisés formulés successivement par l'auditeur.

**7.** Dispositif selon une des revendications 1 à 6 caractérisé en ce que l'amplificateur commande le volume de sortie selon un gain indexé sur les réglages formulés initialement par l'auditeur.

**8.** Dispositif selon une des revendications 1 à 7 caractérisé en ce qu'il comprend des moyens pour détecter un son de parole dans le signal (NL) de mesure subjective de bruit et pour réduire le volume sonore de l'équipement acoustique lorsqu'un son de parole est détecté.

**9.** Dispositif selon une des revendications 1 à 8 caractérisé en ce qu'il comprend des moyens pour différencier un son de parole d'un son musical dans le signal (S2) de sortie de l'équipement acoustique et pour adapter en conséquence un rapport basse/aigu dudit signal d'après la mesure subjective de bruit.

**10.** Application du dispositif de commande automatique selon une des revendications 1 à 9 à la commande automatique de la puissance sonore délivrée par un autoradio, un appareil de reproduction sonore, un téléviseur ou autres.

## FIG.1

**FIG.1**

## FIG.2

**FIG.2**

FIG.3

FIG.4A

FIG.4B

FIG.5

FIG.6

**FIG.7**

**FIG.8**

**FIG.9**

Office européen
des brevets

**RAPPORT DE RECHERCHE EUROPEENNE**

Numero de la demande

EP 94 20 1780

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | PATENT ABSTRACTS OF JAPAN vol. 15, no. 29 (E-1026) 23 Janvier 1991 & JP-A-02 272 814 (OMRON TATEISI ELECTRON) * abrégé * | 1,2 | H03G3/32 |
| A | PATENT ABSTRACTS OF JAPAN vol. 14, no. 257 (E-0936) 4 Juin 1990 & JP-A-02 078 311 (OMRON TATESI ELECTRON) * abrégé * | 1 | |
| A | US-A-5 204 971 (M. TAKAHASHI ET AL.) * le document en entier * | 1 | |
| A | DE-A-33 15 150 (PIONEER) * page 6, ligne 15 - page 7, ligne 32 * | 1 | |
| D,A | PATENT ABSTRACTS OF JAPAN vol. 16, no. 546 (E-1291) 16 Novembre 1992 & JP-A-04 207 611 (OKI ELECTRIC) * abrégé * | 1 | |

DOMAINES TECHNIQUES
RECHERCHES (Int.Cl.6)

H03G

Le présent rapport a été établi pour toutes les revendications

| Lieu de la recherche | Date d'achèvement de la recherche | Examinateur |
|---|---|---|
| LA HAYE | 7 Octobre 1994 | Blaas, D-L |

EPO FORM 1503 03.82 (P04C02)